# EUROPÄISCHE PATENTSCHRIFT

(11) **EP 0 541 164 B1**
(45) Veröffentlichungstag und Bekanntmachung des Hinweises auf die Patenterteilung: **14.05.1997**
(21) Anmeldenummer: 92203331.1
(22) Anmeldetag: 29.10.1992
(51) Int. Cl.: H03F 3/30

(54) **Verstärker**
Amplifier
Amplificateur

(30) Priorität: 07.11.1991 DE 4136605
(43) Veröffentlichungstag der Anmeldung: 12.05.1993
(73) Patentinhaber: Philips Patentverwaltung GmbH, 22335 Hamburg (DE); Philips Electronics N.V., 5621 BA Eindhoven (NL)
(72) Erfinder: Kordts, Jürgen, c/o Philips Patentverwaltung, W-2000 Hamburg 1 (DE); Näthe, Axel, c/o Philips Patentverwaltung, W-2000 Hamburg 1 (DE); Sonnenberger, Paul, c/o Philips Patentverwaltung, W-2000 Hamburg 1 (DE)
(74) Vertreter: von Laue, Hanns-Ulrich, Dipl.-Ing.

(56) Entgegenhaltungen:
- EP-A- 0 295 221
- EP-A- 0 366 253
- WO-A-82/02805
- DE-A- 3 142 607
- GB-A- 2 139 841
- US-A- 3 693 106
- US-A- 3 900 790
- US-A- 4 940 949

## Beschreibung

Die Erfindung betrifft einen Verstärker mit einer Stromspiegelschaltung und einer Stromaufteilungsschaltung, welche ein dem Verstärker zugeführtes Eingangssignal polaritätsabhängig aufspaltet, wobei negative Eingangsströme, die aus dem Verstärker herausfließen, der Stromspiegelschaltung zugeführt werden, deren gesteuerter Ausgangsstrom einem Steuereingang einer ersten im Verstärker vorgesehenen Stromverstärkerschaltung zugeführt wird, wobei positive Eingangsströme, die in den Verstärker hineinfließen, einem Steuereingang einer zweiten im Verstärker vorgesehenen Stromverstärkerschaltung zugeführt werden, welche gleiche Bauweise wie die erste Stromverstärkerschaltung aufweist, wobei die erste Stromverstärkerschaltung mit einer positiven Versorgungsspannung und die zweite Stromverstärkerschaltung mit einer negativen Versorgungsspannung beaufschlagt sind und wobei beide Stromverstärkerschaltungen ausgangsseitig auf eine gemeinsame Last arbeiten.

Aus der US-PS 4,446,443 ist ein Verstärker bekannt, bei welchem zwei Stromspiegel vorgesehen sind, die eine Endstufenschaltung mit zwei Transistoren ansteuern. Es ist dort eine Stromaufteilungsschaltung mit ebenfalls zwei Transistoren vorgesehen, welche zwei Widerstände aufweist, mit der ein Eingangssignal, das spannungsgesteuert ist, in Stromsignale für die Stromspiegel umgewandelt wird.

Aus US-PS 3,900,790 ist eine Stromquelle bekannt, die in Abhängigkeit eines Eingangssignales ein konstantes Strom-Ausgangssignal liefert. In dieser Stromquellenschaltung sind zwei Stromspiegelschaltungen vorgesehen, welche einen Ausgangstransistor ansteuern. Ein weiterer Ausgangstransistor wird von einer der Stromspiegelschaltungen sowie in Abhängigkeit des Eingangssignales angesteuert.

Es ist Aufgabe der Erfindung, einen Verstärker der eingangs genannten Art anzugeben, welcher möglichst einfach im Aufbau ist und der ein Ausgangssignal liefert, das möglichst frei von Übernahmeverzerrungen im Bereich geringer Aussteuerung ist.

Diese Aufgabe ist erfindungsgemäß dadurch gelöst, daß die Stromaufteilerschaltung einen ersten npn-Transistor aufweist, dessen Emitter den Eingang der Stromaufteilerschaltung darstellt und mit dem Steuereingang der zweiten Stromverstärkerschaltung verbunden ist, dessen Kollektor den Steuerstrom für den Stromspiegel liefert und dessen Basis mit der Basis und dem Kollektor eines zweiten npn-Transistors verbunden ist, dessen Kollektor ein Referenzstrom zugeführt wird und dessen Emitter mit den negativen Versorgungsspannung gekoppelt ist.

Bei dem erfindungsgemäßen Verstärker sind also zwei Stromverstärkerschaltungen vorgesehen, welche in gleicher Weise aufgebaut sind und somit auch gleiches Verhalten haben. Damit beide Stromverstärkerschaltungen symmetrisch arbeiten, ist eine Stromaufteilungsschaltung vorgesehen, welche positive Eingangsströme, die in den Verstärker hineinfließen, direkt einem Steuereingang der zweiten Stromverstärkerschaltung zuführt. Ströme umgekehrter Polarität, also negative Ströme, die aus dem Verstärker herausfließen, sollen den Steuereingang der ersten Stromverstärkerschaltung in gleicher Weise ansteuern. Dafür ist zusätzlich eine Stromspiegelschaltung vorgesehen, welche dafür sorgt, daß die erste Stromverstärkerschaltung für negative Ströme in gleicher Weise angesteuert wird, wie die zweite Stromverstärkerschaltung für positive Eingangsströme. Es wird auf diese Weise ein vollständig symmetrisches Verhalten des Verstärkers erzielt.

Die beiden Stromverstärkerschaltungen werden über Ströme angesteuert, so daß in der Ansteuerschaltung geringe Spannungsänderungen auftreten, so daß in dieser vorhandene parasitäre Kapazitäten nur gering umgeladen werden müssen. Ferner gewährleistet der Aufbau des Verstärkers, daß die Ausgangsspannung nicht unter die negative Versorgungsspannung abtaucht, so daß bei einem Aufbau des Verstärkers als integrierter Schaltkreis kein sogenannter parasitärer Effekt eintritt. Der Verstärker weist keine pnp-Transistoren in den Leistungsstufen auf. Dadurch wird eine relativ hohe Stabilität gewährleistet. Diese Vorteile werden bei geringem schaltungstechnischem Aufwand erreicht.

Die Stromaufteilerschaltung ist als Stromspiegel ausgeführt. Ist der Eingangsstrom Null, so fließt durch die Transistoren der beiden Stromverstärkerschaltungen ein Querstrom, der also nicht durch die Last fließt. Der Umschaltpunkt dieses Querstroms bei geringem negativem oder geringem positivem Eingangsstrom ist bei einfachen Stromaufteilerschaltungen temperaturabhängig. Bei Verwendung eines Stromspiegels kann diese Temperaturabhängigkeit weitgehend ausgeschaltet werden, so daß sich der Ruhestrom nur noch geringfügig ändert und die Übernahmeverzerrung klein bleiben. Gemäß einer weiteren Ausgestaltung der Erfindung ist für einen solchen Stromspiegel vorgesehen, daß die Stromaufteilerschaltung einen ersten npn-Transistor aufweist, dessen Emitter den Eingang der Stromaufteilerschaltung darstellt und mit dem Steuereingang der zweiten Stromverstärkerschaltung verbunden ist, dessen Kollektor den Steuerstrom für den Stromspiegel liefert und dessen Basis mit der Basis und dem Kollektor eines zweiten npn-Transistors verbunden ist, dessen Kollektor ein Referenzstrom zugeführt wird und dessen Emitter mit den negativen Versorgungsspannung gekoppelt ist. Ein positiver Eingangsstrom, der in den Verstärker hineinfließt, gelangt fast ausschließlich auf den Steuereingang der zweiten Stromverstärkerschaltung, da der erste Transistor der Stromaufteilerschaltung sperrt. Bei einem negativen Eingangsstrom, der aus dem Verstärker herausfließt, fließt dieser Strom im wesentlichen durch den ersten Transistor der Stromaufteilerschaltung und gelangt über die Stromspiegelschaltung auf den Steuereingang der ersten Stromverstärkerschaltung.

Die dem Emitter des zweiten Transistors der Stromaufteilungsschaltung bzw. des Stromspiegels zugeführte Referenzspannung ist in Abhängigkeit des an der Basisemitterstrecke des oder der Transistoren in der zweiten Stromverstärkerschaltung abfallenden Spannung zu wählen. Es ist daher nach weiteren Ausgestaltungen der Erfindung vorgesehen, daß für die erste Ausführungsform eine Diode zwischen dem zweiten Transistor der Stromaufteilungsschaltung und der negativen Versorgungsspannung geschaltet ist. Für die zweite Ausführungsform mit einer Darlington-Schaltung sind zwei Dioden in Reihe geschaltet. Für die dritte Ausführungsform mit Feldeffekttransistoren in den Stromverstärkerschaltungen genügt ein einfacher Widerstand.

In weiterer Ausgestaltung der Erfindung ist für eine erste Ausführungsform vorgesehen, daß in der ersten Stromverstärkerschaltung ein npn-Transistor vorgesehen ist, dessen Kollektor mit der positiven Versorgungsspannung und dessen Emitter mit der Last verbunden ist und dessen Basis den Steuereingang darstellt, und daß in der zweiten Stromverstärkerschaltung ein npn-Transistor vorgesehen ist, dessen Kollektor mit der Last und dessen Emitter mit der negativen Versorgungsspannung verbunden ist und dessen Basis den Steuereingang darstellt und daß die Kopplung des Emitters des zweiten Transistors der Stromaufteilerschaltung auf die negative Versorgungsspannung über eine Diode vorgenommen wird, welche anodenseitig mit dem Emitter des zweiten Transistors verbunden ist.

In dieser ersten Ausführungsform arbeiten die beiden Stromverstärkerschaltungen mit je einem npn-Transistor. Trotz des einfachen Aufbaus der Schaltung werden die oben beschriebenen Vorteile erzielt. Insbesondere haben npn-Transistoren gegenüber Ausgangsschaltungen mit pnp-Transistoren den Vorteil der größeren Stabilität.

Gemäß einer weiteren Ausgestaltung der Erfindung ist für eine zweite Ausführungsform vorgesehen, daß beide Stromverstärkerschaltungen jeweils eine Darlington-Schaltung mit jeweils zwei npn-Transistoren aufweisen, wobei in der ersten Stromverstärkerschaltung die Kollektoren der beiden Transistoren mit Versorgungsspannung und der Emitter des Ausgangstransistors mit der Last verbunden ist und wobei die Kollektoren der beiden Transistoren der zweiten Stromverstärkerschaltung mit der Last und der Emitter des Ausgangstransistors mit der negativen Versorgungsspannung verbunden ist und daß die Kopplung des Emitters des zweiten Transistors der Stromaufteilerschaltung mit der negativen Versorgungsspannung über zwei gleichsinnig in Reihe geschaltete Dioden vorgenommen wird, von denen eine anodenseitig mit dem Emitter des zweiten Transistors verbunden ist.

Durch die Darlington-Schaltungen kann eine hohe Stromverstärkung erzielt werden, da die resultierende Stromverstärkung sich aus der Multiplikation der Stromverstärkungswerte der Einzeltransistoren einer Darlington-Schaltung ergibt. Bei der aus der US-PS 4 446 443 bekannten Verstärkerschaltung kann eine dermaßen hohe Stromverstärkung nur durch entsprechende Auslegung des zweiten Stromspiegels erzielt werden, was jedoch einen sehr viel höheren Aufwand bedeutet.

Gemäß einer weiteren Ausgestaltung der Erfindung ist für die erste und zweite Ausführungsform vorgesehen, daß der Stromaufteilungsschaltung eingangsseitig ein Widerstand vorgeschaltet ist, welcher so dimensioniert ist, daß die Stromaufteilerschaltung eingangsseitig etwa den gleichen Eingangswiderstand wie die Steuereingänge der Stromverstärkerschaltungen aufweist.

Durch diesen Vorwiderstand am Eingang der Stromaufteilungsschaltung wird erreicht, daß der Eingangsstrom unabhängig von seiner Polarität auf etwa den gleichen Eingangswiderstand trifft. Bei der einen Polarität wird der Eingangsstrom auf einen Steuereingang der einen Stromverstärkerschaltung geschaltet. Bei der anderen Polarität sorgt die Stromaufteilungsschaltung dafür, daß der Strom über die Stromspiegelschaltung auf den Steuereingang der anderen Stromverstärkerschaltung gelangt. In diesem Falle bildet also der Eingang der Stromaufteilungsschaltung den Eingangswiderstand, der mittels des Widerstandes etwa gleich gewählt werden kann, wie die Eingangswiderstände der Stromverstärkerschaltungen.

In einer weiteren Ausgestaltung der Erfindung ist für eine dritte Ausführungsform vorgesehen, daß in der ersten Stromverstärkerschaltung ein Feldeffekttransistor (31) vorgesehen ist, dessen Source-Anschluß mit der positiven Versorgungsspannung und dessen Drain-Anschluß mit der Last verbunden ist und dessen Gate-Anschluß, der über einen Widerstand mit dem Drain-Anschluß verbunden ist, den Steuereingang der ersten Stromverstärkerschaltung bildet und daß in der zweiten Stromverstärkungsschaltung ein Feldeffekttransistor vorgesehen ist, dessen Source-Anschluß mit der Last und dessen Drain-Anschluß mit der negativen Versorgungsspannung verbunden ist und dessen Gate-Anschluß, der über einen Widerstand mit dem Drain-Anschluß verbunden ist, den Steuereingang der zweiten Stromverstärkerschaltung darstellt und daß die Kopplung des Emitters des zweiten Transistors der Stromaufteilerschaltung mit der negativen Versorgungsspannung über einen Widerstand vorgenommen wird.

Der Einsatz von Feldeffekttransistoren in den Stromverstärkerschaltungen hat vor allem den Vorteil, daß aufgrund des geringen Drain-Source-Durchlaßwiderstandes (RD_{ON}) kleine Sättigungsspannungen und damit gegenüber Lösungen mit npn-Transistoren geringere Verlustleistungen erreichbar sind.

Anhand der Zeichnung werden drei Ausführungsformen der Erfindung näher erläutert. Es zeigen:
Fig. 1 eine erste Ausführungsform des erfindungsgemäßen Verstärkers mit je einem npn-Transistor in den Stromverstärkerstufen,
Fig. 2 eine zweite Ausführungsform mit je einer Darlington-Schaltung in den Stromverstärkerschaltungen und
Fig. 3 eine dritte Ausführungsform mit je einem Feldeffekttransistor in den Stromverstärkerschaltungen.

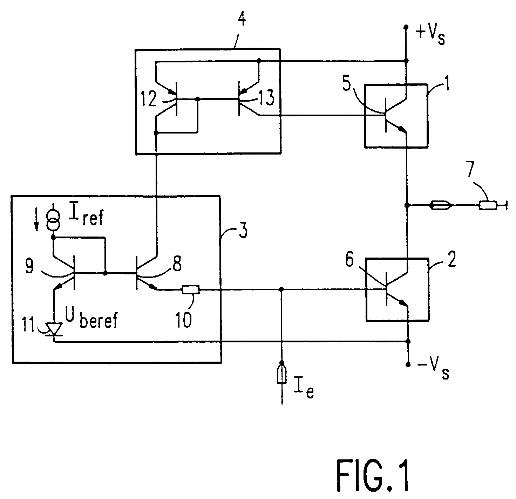

Eine erste in der Fig. 1 dargestellte Ausführungsform weist eine erste Stromverstärkerstufe 1, eine zweite Stromverstärkerstufe 2, eine Stromaufteilungsschaltung 3 und eine Stromspiegelschaltung 4 auf. Die erste Stromverstärkerschaltung 1 weist einen npn-Transistor 5 auf, dessen Kollektor mit einer positiven Versorgungsspannung + Vₛ verbunden ist. Der Emitter des Transistors 5 ist mit dem Kollektor eines in der zweiten Stromverstärkerschaltung 2 vorgesehenen npn-Transistors 6 verbunden. Dieser Verbindungspunkt zwischen dem Emitter des Transistors 5 und dem Kollektor des Transistors 6 stellt den Ausgang des Verstärkers dar, der beispielsweise, wie in der Fig. 1 angedeutet, auf eine Last 7 geführt sein kann. Der Emitter des Transistors 6 ist mit einer negativen Versorgungsspannung - Vₛ verbunden. Die beiden Basisanschlüsse der Transistoren 5 und 6 stellen die Steuereingänge der Stromverstärkerschaltungen 1 bzw. 2 dar.

Ein dem in der Fig. 1 dargestellten Verstärker zugeführter Eingangsstrom Iₑ wird sowohl dem Steuereingang der zweiten Stromverstärkerschaltung 2 wie auch der Stromaufteilerschaltung 3 zugeführt.

In der Stromaufteilerschaltung 3 ist eine Stromspiegelschaltung mit einem ersten Transistor 8 und einem zweiten Transistor 9 vorgesehen, welche beide als npn-Transistoren vorgesehen sind.

Der Eingangsstrom Iₑ gelangt über einen Widerstand 10 auf den Emitter des ersten Transistors 8, dessen Kollektor den Ausgangsstrom der Stromaufteilerschaltung liefert, der auf den Stromspiegel 4 geführt ist.

Die Basis des ersten Transistors 8 der Stromaufteilerschaltung 3 ist mit der Basis des zweiten Transistors 9 sowie mit dessen Kollektor verbunden. Dem Kollektor des Transistors 9 ist ferner ein Referenzstrom I_{ref} zugeführt. Der Emitter des Transistors 9 ist über eine Diode 11 mit der negativen Versorgungsspannung - Vₛ verbunden, wobei die Diode 11 anodenseitig mit dem Emitter des Transistors 9 verbunden ist.

Der vom Kollektor des ersten Transistors 8 der Stromaufteilerschaltung 3 gelieferte Strom gelangt auf eine 4, in der zwei pnp-Transistoren in an sich bekannter Weise als Stromspiegelschaltung verschaltet sind. Es ist ein erster Transistor 12 vorgesehen, dessen Kollektor und dessen Basis der von der Stromaufteilerschaltung 3 kommende Strom zugeführt wird. Der Emitter dieses Transistors 12 sowie der Emitter eines zweiten Transistors 13 der Stromspiegelschaltung 4 sind mit der positiven Versorgungsspannung + Vₛ verbunden. Die Basen dieser beiden Transistoren sind miteinander verbunden. Der Kollektor des zweiten Transistors 13 liefert das Ausgangssignal der Stromspiegelschaltung 4, das auf den Steuereingang der ersten Stromverstärkerschaltung 1 geführt ist.

Im folgenden wird die Arbeitsweise des Verstärkers gemäß Fig. 1 näher erläutert:

Für die nachfolgende Beschreibung wird davon ausgegangen, daß ein positiver Eingangsstrom Iₑ als ein in den Verstärker hineinfließenden Strom definiert ist und daß ein negativer Eingangsstrom als ein aus dem Verstärker herausfließender Eingangsstrom angesehen wird.

Der Eingangsstrom Iₑ wird in Abhängigkeit seines Vorzeichens mit Hilfe der Stromaufteilerschaltung 3 und des Stromspiegels 4 auf die Steuereingänge der beiden Stromverstärkerschaltungen 1 und 2 verteilt. Ist der Strom positiv, so fließt der gesamte Strom in den Steuereingang der zweiten Stromverstärkerschaltung 2, so daß infolge des Stromverstärkungsfaktors des Transistors 6 ein entsprechender höherer Strom in der Last fließt. Dieser Strom wird bei Aktivierung des Transistors 6 der zweiten Stromverstärkerschaltung quasi aus der Last 7 herausgezogen und fließt gegen die Versorgungsspannung - Vₛ. Bei negativem Eingangsstrom gelangt dieser über die Stromaufteilerschaltung 3 und den Stromspiegel 4 auf den Steuereingang der ersten Stromverstärkerschaltung 1, so daß in Abhängigkeit des Stromverstärkungsfaktors des Transistors 5 ein entsprechender Strom von + Vₛ in die Last 7 fließt. Der in den Steuereingang der ersten Stromverstärkerschaltung 1 fließende Strom ist dabei ein genaues Abbild des Eingangsstromes, jedoch mit umgekehrter Polarität. Auf diese Weise wird ein vollständig symmetrisches Verhalten der Schaltung erzielt.

Im nachfolgenden wird die Arbeitsweise der Stromaufteilerschaltung näher erläutert:

Es wird zunächst angenommen, daß der Eingangsstrom Iₑ gleich Null ist. In Abhängigkeit des dem zweiten Transistor 9 der Stromaufteilerschaltung zugeführten Referenzstromes I_{ref} und der durch die Diode 11 erzeugten Referenzspannung U_{beref} fließt dann ein Kollektorstrom in dem ersten Transistor 8 der Stromaufteilerschaltung 3. Nahezu der gleiche Strom fließt aus dem Emitter des Transistors 8 heraus und gelangt an den Steuereingang der zweiten Stromverstärkerschaltung, also an die Basis von Transistor 6. Der Kollektorstrom des Transistors 8 der Stromaufteilerschaltung 3 gelangt an die Stromspiegelschaltung 4 und über diese mit umgekehrter Polarität an den Steuereingang der ersten Stromverstärkerschaltung 1 bzw. an die Basis dessen Transistors 5. Es wird also beiden Steuereingängen der Stromverstärkerschaltungen der gleiche Strom zugeführt, so daß die Basisströme der Transistoren 5 und 6 gleich groß sind und in den Kollektoren ebenfalls die gleichen Ströme fließen. Durch die Last 7 fließt in diesem Falle kein Strom; die Anordnung befindet sich im Übernahmepunkt.

Ist der Eingangsstrom Iₑ positiv, fließt er also in die Schaltung hinein, so gelangt dieser Strom vollständig auf die Basis des Transistors 6, also dem Steuereingang der zweiten Stromverstärkerschaltung 2. Die Basisemitterspannung am Transistor 6 steigt entsprechend an, so daß die Basisemitterspannung des Transistors 8 der Stromaufteilerschaltung 3 entsprechend kleiner wird. Dies führt dazu, daß der Transistor 8 schnell sperrt, so daß sein Kollektorstrom zu Null wird. Somit erhält die Stromspiegelschaltung 4 keinen Strom mehr, so daß auch dem Steuereingang der ersten Stromverstärkerschaltung 5 kein Strom mehr zugeführt wird, was wiederum dazu führt, daß der Transistor 5 sperrt. Es fließt also ausschließlich ein Strom aus der Last heraus, der durch die zweite Stromverstärkerschaltung 2 gesteuert wird.

Ist der Eingangsstrom Iₑ dagegen negativ, so fließt dieser Strom vollständig durch den Transistor 8 der Stromaufteilerschaltung 3 und gelangt durch den Stromspiegel 4 auf den Steuereingang der ersten Stromverstärkerschaltung 1 bzw. auf die Basis deren Transistors 5. Da dieser Eingangsstrom Iₑ durch den Transistor 8 fließt, steigt dessen Basisemitterspannung an, so daß die Basisemitterspannung des Transistors 6 der zweiten Stromverstärkerschaltung 2 entsprechend kleiner wird und somit dieser Transistor schnell sperrt. Bei negativem Eingangsstrom wird also der durch die Last 7 fließende Strom ausschließlich durch die erste Stromverstärkerschaltung 1 bestimmt. Es fließt ein Strom von der positiven Versorgungsspannung + Vₛ zur Last 7.

Die beiden Transistoren 8 und 9 bilden zusammen mit ihrer Verschaltung einen Stromspiegel in der Stromaufteilerschaltung 3. Dieser Stromspiegel hat vor allem den Vorteil, daß der Ruhestrom, der bei Eingangsstrom Iₑ = 0 durch die beiden Transistoren 5 und 6 fließt, nicht temperaturabhängig ist. Es muß hierfür gelten, daß die Diode 11 die gleiche Temperatur aufweisen muß wie der Transistor 6 der zweiten Stromverstärkerschaltung. Diese Bedingung kann bei integrierter Bauweise leicht erfüllt werden. Auch Bauteilestreuungen bewirken nur eine geringe Veränderung dieses Ruhestroms. Der in dem Eingang der Stromaufteilerschaltung 3 vorgesehene Widerstand 10 hat vor allem den Vorteil, daß über ihn ein zusätzlicher Spannungsabfall erfolgt, welcher dafür sorgt, daß schon bei kleinem negativen Eingangsstrom Iₑ die Basisemitterspannung des Transistors 6 so klein wird, daß der Transistor 6 frühzeitig sperrt.

Die Schaltung hat ferner den Vorteil, daß der sogenannte parasitäre Effekt verhindert wird. Dazu ist es erforderlich zu verhindern, daß die Ausgangsspannung unter - Vₛ sinkt. Hat z.B. die Last 7 induktives Verhalten, so wird bei schnellen Schaltvorgängen eine Spannung induziert, die dafür sorgt, daß die Kollektorspannung des Transistors 6 unter - Vₛ abtauchen möchte. Die Basis des Transistors 6 liegt auf einem Potential, das um eine Basisemitterspannung höher ist als - Vₛ. Läuft die Kollektorspannung vom Transistor 6 nun gegen - Vₛ, so wird die Kollektorbasisdiode invers leitend und es fließt ein Strom vom Emitter des Transistors 8 über die leitende Basiskollektorstrecke des Transistors 6 in die Last hinein. Damit fließt auch im Kollektor des Transistors 8 ein Strom, der mit dem Stromspiegel 3 in die Basis des Transistors 5 der ersten Stromverstärkerschaltung 1 gespiegelt wird. Dadurch wird der Transistor 5 leitend und wirkt dem weiteren Abtauchen der Kollektorspannung des Transistors 6 entgegen, so daß dieses Potential bei - Vₛ geklemmt wird und kein Abtauchen unter dieses Potential stattfindet.

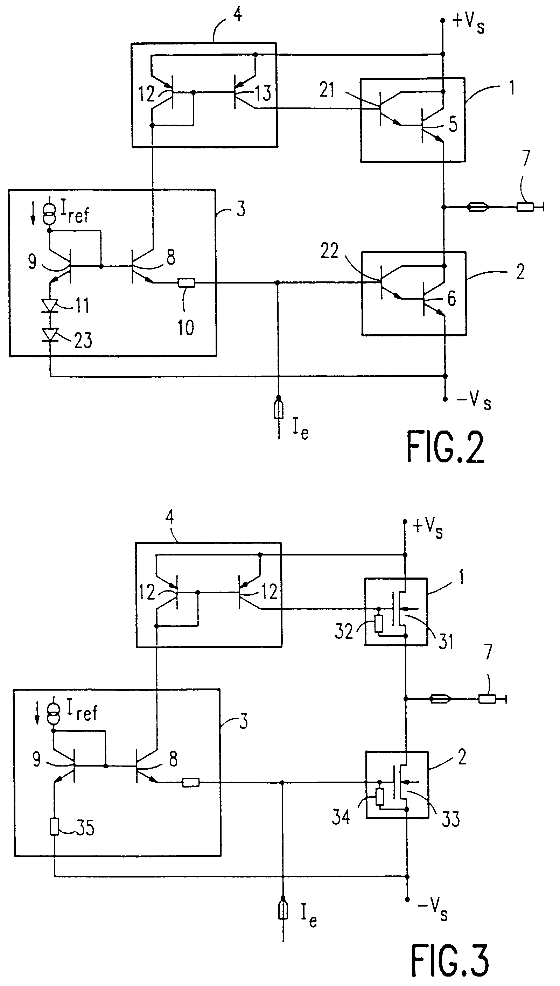

Die Schaltung gemäß Fig. 1 liefert gegenüber dem Eingangsstrom Iₑ eine Stromverstärkung entsprechend der Stromverstärkungen der beiden Endtransistoren 5 und 6. In manchen Fällen ist eine höhere Stromverstärkung wünschenswert, welche auf einfache Weise mit einer in Fig. 2 dargestellten zweiten Ausführungsform der Verstärkerschaltung erzielt werden kann. Der in Fig. 2 dargestellte Verstärker weist weitgehend den gleichen Aufbau auf wie der in Fig. 1 dargestellte Verstärker. Der Verstärker gemäß Fig. 2 unterscheidet sich nur durch den Aufbau der beiden Stromverstärkerschaltungen 1 und 2 und durch eine entsprechende Anpassung der Stromspiegelschaltung der Stromaufteilerschaltung 3.

In der ersten Stromverstärkerschaltung 1 der Schaltung gemäß Fig. 2 ist zusätzlich zu dem Transistor 5 ein weiterer Transistor 21 vorgesehen, der zusammen mit dem Transistor 5 eine Darlington-Schaltung bildet. Der Kollektor des Transistors 21 ist mit der positiven Versorgungsspannung + Vₛ und dem Kollektor des Transistors 5 verbunden. Der Emitter des Transistors 21 ist mit der Basis des Transistors 5 verbunden. Die Basis des Transistors 21 bildet den Steuereingang der Stromverstärkungsschaltung 1. Der Emitter des Transistors 5 ist weiterhin mit der Last 7 verbunden.

In der zweiten Stromverstärkungsschaltung ist zusätzlich zu dem Transistor 6 ein Transistor 22 vorgesehen, welche in entsprechender Weise eine Darlington-Schaltung mit dem Transistor 6 bildet. Die Basis des Transistors 22 bildet dabei den Steuereingang der zweiten Stromverstärkerschaltung 2.

Für die Arbeitsweise der Stromaufteilerschaltung 3 bzw. der in ihr vorgesehenen Stromspiegelschaltung ist zu berücksichtigen, daß die Darlington-Schaltung mit den beiden Transistoren 6 und 22 zwei Basisemitterstrecken bildet, so daß in der Stromaufteilungsschaltung 3 zusätzlich zu der Diode 11 eine weitere Diode 23 vorzusehen ist. Mittels der Schaltung gemäß Fig. 2 wird eine Stromverstärkung erreicht, welche sich aus der Multiplikation der Stromverstärkungsfaktoren der Transistoren 21 und 5 bzw. 22 und 6 bildet. Es wird hier eine sehr hohe Stromverstärkung mit äußerst einfachem Aufbau erzielt.

In Fig. 3 ist eine dritte Ausführungsform des erfindungsgemäßen Verstärkers dargestellt, welche mit der zweiten Ausführungsform gemäß Fig. 2 bzw. der ersten Ausführungsform gemäß Fig. 1 weitgehend identischen Aufbau hat, jedoch mit der Ausnahme, daß in den Stromverstärkerschaltungen 1 bzw. 2 jeweils ein Feldeffekttransistor vorgesehen ist.

In der ersten Stromverstärkerschaltung 1 ist ein Feldeffekttransistor 31 vorgesehen, welcher mit seinem Source-Anschluß mit der positiven Versorgungsspannung + Vₛ verbunden ist. Der Gate-Anschluß des Feldeffekttransistors 31 bildet den Steuereingang der Stromverstärkerschaltung 1 und ist über einen Widerstand 32 mit dem Drain-Anschluß des Feldeffekttransistors 31 verbunden, welcher auf die Last 7 geführt ist.

In der zweiten Stromverstärkerschaltung 2 ist ein Feldeffekttransistor 33 vorgesehen, dessen Source-Anschluß mit der Last 7 verbunden ist. Der Drain-Anschluß des Transistors 33 ist auf die negative Versorgungsspannung - Vₛ geführt und ist über einen Widerstand 34 mit dem Gate-Anschluß des Feldeffekttransistors 33 verbunden, der auch den Steuereingang der Stromverstärkerschaltung 2 bildet.

Auch für die dritte Ausführungsform gemäß Fig. 3 ist die Referenzspannung bzw. die Kupplung des Transistors 9 der Stromspiegelschaltung in der Aufteilerschaltung 3 mit der negativen Versorgungsspannung - Vₛ entsprechend dem Spannungsabfall zwischen dem Steuereingang der zweiten Stromverstärkerschaltung 2 und der Versorgungsspannung - Vₛ anzupassen. Es ist daher zwischen dem Emitter des zweiten Transistors 9 und der negativen Versorgungsspannung - Vₛ ein Widerstand 35 vorgesehen.

Die Arbeitsweise der Schaltung der zweiten Ausführungsform gemäß Fig. 2 sowie der Schaltung der dritten Ausführungsform gemäß Fig. 3 entspricht der Arbeitsweise der Schaltung der ersten Ausführungsform gemäß Fig. 1 mit den oben bereits erläuterten Abweichungen.

## Patentansprüche

1. Verstärker mit einer Stromspiegelschaltung (4) und einer Stromaufteilungsschaltung (3), welche ein dem Verstärker zugeführtes Eingangssignal polaritätsabhängig aufspaltet, wobei negative Eingangsströme, die aus dem Verstärker herausfließen, der Stromspiegelschaltung (4) zugeführt werden, deren gesteuerter Ausgangsstrom einem Steuereingang einer ersten im Verstärker vorgesehenen Stromverstärkerschaltung (1) zugeführt wird, wobei positive Eingangsströme, die in den Verstärker hineinfließen, einem Steuereingang einer zweiten im Verstärker vorgesehenen Stromverstärkerschaltung (2) zugeführt werden, welche gleiche Bauweise wie die erste Stromverstärkerschaltung (1) aufweist, wobei die erste Stromverstärkerschaltung (1) mit einer positiven Versorgungsspannung und die zweite Stromverstärkerschaltung (2) mit einer negativen Versorgungsspannung beaufschlagt sind und wobei beide Stromverstärkerschaltungen (1, 2) ausgangsseitig auf eine gemeinsame Last (7) arbeiten, dadurch gekennzeichnet,
daß die Stromaufteilerschaltung als Stromspiegel ausgeführt ist und daß die Stromaufteilerschaltung einen ersten npn-Transistor (8) aufweist, dessen Emitter den Eingang der Stromaufteilerschaltung (3) darstellt und mit dem Steuereingang der zweiten Stromverstärkerschaltung verbunden ist, dessen Kollektor den Steuerstrom für den Stromspiegel (4) liefert und dessen Basis mit der Basis und dem Kollektor eines zweiten npn-Transistors (9) verbunden ist, dessen Kollektor ein Referenzstrom zugeführt wird und dessen Emitter mit den negativen Versorgungsspannung gekoppelt ist.

2. Verstärker nach Anspruch 1, dadurch gekennzeichnet*,*
daß in der ersten Stromverstärkerschaltung (1) ein npn-Transistor (5) vorgesehen ist, dessen Kollektor mit der positiven Versorgungsspannung und dessen Emitter mit der Last verbunden ist und dessen Basis den Steuereingang darstellt, und daß in der zweiten Stromverstärkerschaltung (2) ein npn-Transistor (6) vorgesehen ist, dessen Kollektor mit der Last und dessen Emitter mit der negativen Versorgungsspannung verbunden ist und dessen Basis den Steuereingang darstellt und daß die Kopplung des Emitters des zweiten Transistors der Stromaufteilerschaltung auf die negative Versorgungsspannung über eine Diode (11) vorgenommen wird, welche anodenseitig mit dem Emitter des zweiten Transistors (9) verbunden ist.

3. Verstärker nach Anspruch 1, dadurch gekennzeichnet,
daß beide Stromverstärkerschaltungen jeweils eine Darlington-Schaltung mit jeweils zwei npn-Transistoren (5 und 21, 6 und 22) aufweisen, wobei in der ersten Stromverstärkerschaltung (1) die Kollektoren der beiden Transistoren (5, 21) mit Versorgungsspannung und der Emitter des Ausgangstransistors (5) mit der Last (7) verbunden ist und wobei die Kollektoren (6, 21) der beiden Transistoren der zweiten Stromverstärkerschaltung (2) mit der Last (7) und der Emitter des Ausgangstransistors (6) mit der negativen Versorgungsspannung verbunden ist und daß die Kopplung des Emitters des zweiten Transistors (9) der Stromaufteilerschaltung mit der negativen Versorgungsspannung über zwei gleichsinnig in Reihe geschaltete Dioden (11, 23) vorgenommen wird, von denen eine (11) anodenseitig mit dem Emitter des zweiten Transistors (9) verbunden ist.

4. Verstärker nach Anspruch 2 oder Anspruch 3,
dadurch gekennzeichnet, daß der Stromaufteilungsschaltung (3) eingangsseitig ein Widerstand (10) vorgeschaltet ist, welcher so dimensioniert ist, daß die Stromaufteilerschaltung (3) eingangsseitig etwa den gleichen Eingangswiderstand wie die Steuereingänge der Stromverstärkerschaltungen (12) aufweist.

5. Verstärker nach Anspruch 1,
dadurch gekennzeichnet, daß in der ersten Stromverstärkerschaltung (1) ein Feldeffekttransistor (31) vorgesehen ist, dessen Source-Anschluß mit der positiven Versorgungsspannung und dessen Drain-Anschluß mit der Last verbunden ist und dessen Gate-Anschluß, der über einen Widerstand (32) mit dem Drain-Anschluß verbunden ist, den Steuereingang der ersten Stromverstärkerschaltung (1) bildet und daß in der zweiten Stromverstärkungsschaltung (2) ein Feldeffekttransistor (33) vorgesehen ist, dessen Source-Anschluß mit der Last (7) und dessen Drain-Anschluß mit der negativen Versorgungsspannung verbunden ist und dessen Gate-Anschluß, der über einen Widerstand (34) mit dem Drain-Anschluß verbunden ist, den Steuereingang der zweiten Stromverstärkerschaltung (2) darstellt und daß die Kopplung des Emitters des zweiten Transistors (9) der Stromaufteilerschaltung mit der negativen Versorgungsspannung über einen Widerstand (35) vorgenommen wird.

## Claims

1. An amplifier comprising a current mirror circuit (4) and a current splitting circuit (3) which splits up an input signal applied to the amplifier dependent upon the polarity, in which negative input currents flowing out of the amplifier are applied to the current mirror circuit (4) whose controlled output current is applied to a control input of a first current amplifier circuit (1) arranged in the amplifier, in which positive input currents flowing into the amplifier are applied to a control input of a second current amplifier circuit (2) arranged in the amplifier, which second current amplifier circuit has the same structure as the first current amplifier circuit (1), in which the first current amplifier circuit (1) is connected to a positive power supply voltage and the second current amplifier circuit (2) is connected to a negative power supply voltage, and in which the two current amplifier circuits (1, 2) operate on a common load (7) at their output ends, characterized in that the current splitting circuit comprises a current mirror, and in that the current splitting circuit includes a first NPN transistor (8) whose emitter constitutes the input of the current splitting circuit (3) and which is connected to the control input of the second current amplifier circuit, whose collector supplies the control current for the current mirror (4) and whose base is connected to the base and to the collector of a second NPN transistor (9) whose collector receives a reference current and whose emitter is coupled to the negative power supply voltage.

2. An amplifier as claimed in Claim 1, characterized in that the first current amplifier circuit (1) includes an NPN transistor (5) whose collector is connected to the positive power supply voltage and whose emitter is connected to the load and whose base comprises the control input, and in that the second current amplifier circuit (2) includes an NPN transistor (6) whose collector is connected to the load and whose emitter is connected to the negative power supply voltage and whose base comprises the control input, and in that the emitter of the second transistor of the current splitting circuit is coupled to the negative power supply voltage via a diode (11) whose anode end is connected to the emitter of the second transistor (9).

3. An amplifier as claimed in Claim 1, characterized in that the two current amplifier circuits include a Darlington circuit of two NPN transistors each (5 and 21, 6 and 22), in which the collectors of the two transistors (5, 21) in the first current amplifier circuit (1) are connected to the power supply voltage and the emitter of the output transistor (5) is connected to the load (7), and in which the collectors (6, 21) of the two transistors in the second current amplifier circuit (2) are connected to the load (7) and the emitter of the output transistor (6) is connected to the negative power supply voltage, and in that the emitter of the second transistor (9) of the current splitting circuit is coupled to the negative power supply voltage via two diodes (11, 23) which are series-arranged in the same direction, one diode (11) being connected at its anode end to the emitter of the second transistor (9).

4. An amplifier as claimed in Claim 2 or 3, characterized in that the current splitting circuit (3) is preceded at its input end by a resistor (10) which is dimensioned such that the current splitting circuit (3) has substantially the same input resistance at the input end as the control inputs of the current amplifier circuits (1, 2).

5. An amplifier as claimed in Claim 1, characterized in that the first current amplifier circuit (1) includes a field effect transistor (31) whose source is connected to the positive power supply voltage, whose drain is connected to the load and whose gate, which is connected to the drain via a resistor (32), constitutes the control input of the first current amplifier circuit (1), and in that the second current amplifier circuit (2) includes a field effect transistor (33) whose source is connected to the load (7) and whose drain is connected to the negative power supply voltage and whose gate, which is connected to the drain via a resistor (34), constitutes the control input of the second current amplifier circuit (2), and in that the emitter of the second transistor (9) of the current splitting circuit is coupled to the negative power supply voltage via a resistor (35).

## Revendications

1. Amplificateur avec un circuit réflecteur de courant (4) et un circuit distributeur de courant (3), qui répartit un signal d'entrée amené à l'amplificateur en fonction de la polarité, où les courants d'entrée négatifs qui sortent de l'amplificateur sont amenés au circuit réflecteur de courant (4) dont le courant de sortie commandé est amené à une entrée de commande d'un premier circuit amplificateur de courant (1) prévu dans l'amplificateur, où les courants d'entrée positifs qui pénètrent dans l'amplificateur sont amenés à une entrée de commande d'un deuxième circuit amplificateur de courant (2) prévu dans l'amplificateur qui présente la même conception que le premier circuit amplificateur de courant (1), où le premier circuit amplificateur de courant (1) est alimenté en une tension d'alimentation positive et le deuxième circuit amplificateur de courant (2) est alimenté en une tension d'alimentation négative et les deux circuits amplificateurs de courant (1, 2) travaillent côté sortie sur une charge commune (7), caractérisé en ce que le circuit distributeur de courant est conçu comme un réflecteur de courant et en ce que le circuit distributeur de courant présente un premier transistor npn (8) dont l'émetteur représente l'entrée du circuit distributeur de courant (3) et est relié à l'entrée de commande du deuxième circuit amplificateur de courant dont le collecteur produit le courant de commande pour le niveau de courant (4) et dont la base est reliée à la base et au collecteur d'un deuxième transistor npn (9) au collecteur duquel est amené un courant de référence et dont l'émetteur est couplé à la tension d'alimentation négative.

2. Amplificateur selon la revendication 1, caractérisé en ce que, dans le premier circuit amplificateur de courant (1) est prévu un transistor npn (5) dont le collecteur est relié à la tension d'alimentation positive et dont l'émetteur est relié à la charge et dont la base représente l'entrée de commande et en ce que, dans le deuxième circuit amplificateur de courant (2) est prévu un transistor npn (6) dont le collecteur est relié à la charge et dont l'émetteur est relié à la tension d'alimentation négative et dont la base présente l'entrée de commande et en ce que le couplage de l'émetteur du deuxième transistor du circuit distributeur de courant à la tension d'alimentation négative est assuré par l'intermédiaire d'une diode (11) qui est reliée côté anode à l'émetteur du deuxième transistor (9).

3. Amplificateur selon la revendication 1, caractérisé en ce que les deux circuits amplificateurs de courant présentent respectivement un circuit de Darlington avec respectivement deux transistors npn (5 et 21, 6 et 22), les collecteurs des deux transistors (5, 21) dans le premier circuit amplificateur de courant (1) étant reliés à la tension d'alimentation et l'émetteur du transistor de sortie (5) à la charge (7) et les collecteurs (6, 21) des deux transistors du deuxième circuit amplificateur de courant (2) étant reliés à la charge (7) et l'émetteur du transistor de sortie (6) à la tension d'alimentation négative et en ce que le couplage de l'émetteur du deuxième transistor (9) du circuit distributeur de courant avec la tension d'alimentation négative est assuré par l'intermédiaire de deux diodes montées en série dans le même sens (11, 23) dont l'une (11) est reliée côté anode à l'émetteur du deuxième transistor (9).

4. Amplificateur selon la revendication 2 ou 3, caractérisé en ce qu'une résistance (10) est montée en amont côté entrée du circuit distributeur de courant (3) et dimensionnée de telle sorte que le circuit distributeur de courant (3) présente côté entrée à peu près la même résistance d'entrée que les entrées de commande des circuits amplificateurs de courant (12).

5. Amplificateur selon la revendication 1, caractérisé En ce qu'un transistor à effet de champ (31) est prévu dans le premier circuit amplificateur de courant (1) et sa connexion de source est reliée à la tension d'alimentation positive et sa connexion de drain à la charge et sa connexion de grille qui est reliée par l'intermédiaire d'une résistance (32) à la connexion de drain forme l'entrée de commande du premier circuit amplificateur de courant (1) et en ce qu'il est prévu dans le deuxième circuit amplificateur de courant (2) un transistor à effet de champ (33) dont la connexion de source est reliée à la charge (7), la connexion de drain à la tension d'alimentation négative et la connexion de grille qui est reliée par l'intermédiaire d'une résistance (34) à la connexion de drain représentent l'entrée de commande du deuxième circuit amplificateur de courant (2) et que le couplage de l'émetteur du deuxième transistor (9) du circuit distributeur de courant à la tension d'alimentation négative est assuré par l'intermédiaire d'une résistance (35).
